# EUROPÄISCHE PATENTSCHRIFT

(11) **EP 4 129 025 B1**
(45) Veröffentlichungstag und Bekanntmachung des Hinweises auf die Patenterteilung: **02.12.2026**
(21) Anmeldenummer: 21713930.2
(22) Anmeldetag: 18.03.2021
(51) Int. Cl.: H05K 7/14

(54) **BACKPLANEMODUL ZUM ELEKTRISCHEN VERBINDEN MEHRERER FUNKTIONSMODULE UND MODULAR AUFGEBAUTES KOMMUNIKATIONSSYSTEM**
BACKPLANE MODULE FOR ELECTRICALLY CONNECTING A PLURALITY OF FUNCTIONAL MODULES, AND MODULAR COMMUNICATIONS SYSTEM
MODULE FOND DE PANIER POUR LA LIAISON ÉLECTRIQUE DE PLUSIEURS MODULES FONCTIONNELS ET SYSTÈME DE COMMUNICATION DE CONSTRUCTION MODULAIRE

(30) Priorität: 27.03.2020 DE 102020108610
(43) Veröffentlichungstag der Anmeldung: 08.02.2023
(73) Patentinhaber: PHOENIX CONTACT GMBH & CO. KG, 32825 Blomberg (DE)
(72) Erfinder: MÜLLER, Martin, 32676 Lügde (DE); HELLMANN, Klas, 31787 Hameln (DE)
(74) Vertreter: Blumbach · Zinngrebe Patentanwälte PartG mbB
(86) Internationale Anmeldenummer: PCT/EP2021/057014
(87) Internationale Veröffentlichungsnummer: WO 2021/191055

(56) Entgegenhaltungen:
- EP-A1- 0 345 493
- EP-A1- 2 456 133
- EP-B1- 0 345 493
- WO-A1-2016/151019
- DE-A1- 10 148 470
- DE-T2- 60 123 984

## Beschreibung

Die Erfindung betrifft ein Backplanemodul zum Koppeln mehrerer Funktionsmodule sowie ein modular aufgebautes Kommunikationssystem, welches wenigstens ein derartiges Backplanemodul aufweist.

Backplanesysteme, auch als Rückwandsysteme bekannt, kommen beispielsweise in modular aufgebauten Geräten vor. Ein Backplanesystem kann beispielsweise einen Rückwandbus und mehrere Steckplätze aufweisen, die über den Rückwandbus elektrisch verbunden sind. In die Steckplätze können verschiedene elektronische Module eingesteckt werden.

Ferner ist bekannt, nebeneinander anreihbare Gerätemodule über eine Backplane bzw. Rückwand elektrisch miteinander zu verbinden, wobei zwischen jeweils zwei benachbarten Module eine Punkt-zu-Punkt-Verbindung besteht. In diesem Fall übernimmt jedes Gerätemodul die Weiterleitung von Daten zu einem Modul, dass in Übertragungsrichtung hinter dem weiterleitenden Gerätemodul angeordnet ist. Hierbei besteht jedoch das Problem, dass, wenn eines der Module ausfällt, alle Module, die in Übertragungsrichtung hinter dem defekten Modul liegen, ebenfalls von der Kommunikation abgeschnitten sind. Auch ein Entfernen oder Austausch von Modulen im Betrieb ist nicht ohne Kommunikationsverlust auf andere Module möglich.

Aus der GB 2 404 815 B ist eine paketvermittelte Rückwand bzw. Backplane bekannt, die mehrere Steckplätze aufweist, die elektrisch über die Rückwand verbunden sind. Die bekannte Rückwand ist hierbei als passives Bauelement ausgeprägt, die Steckplätze über Punkt-zu-Punkt-Verbindungen, d.h. in fest vorgegebener Weise, miteinander elektrisch verbinden. Eine einen Ethernet-Switch enthaltende Aggregationskarte kann in einen der Steckplätze eingesteckt werden.

Aus der US 2005/0078706 A1 ist ebenfalls eine paketvermittelte Rückwand bekannt, die über einzelne Punkt-zu-Punkt-Verbindungen oder über einen Bus Vermittlungsknoten und Nutzknoten miteinander verbinden 1 kann.

Aus der DE10148470A1 und der DE60123984T2 ist ein Backplane-Modul, bei dem eine Vielzahl von Steckplätzen für Funktionsmodule zur Verfügung steht, wobei jeder Steckplatz über separate Kommunikationsleitungen mit einer Datenverteilungseinrichtung verbunden ist, bekannt.

Der Erfindung liegt die Aufgabe zugrunde, ein Backplanemodul zum Koppeln mehrerer Funktionsmodule zu schaffen, wobei das Backplanemodul eine flexible elektrische Verbindung seiner Anschlusseinrichtungen sowie eine dynamisch veränderbare Kommunikation zwischen an den Anschlusseinrichtungen angeschlossenen Funktionsmodulen ermöglicht. Eine weitere Aufgabe kann darin gesehen werden, ein modular aufgebautes Kommunikationssystem insbesondere zur industriellen Prozesssteuerung bereitzustellen, welches wenigstens ein solches Backplanemodul aufweist. Darüber hinaus liegt die Aufgabe zugrunde, den Datendurchsatz über die verfügbaren Kommunikationsleitungen zu verbessern.

Ein Kerngedanke der Erfindung kann darin gesehen werden, ein Backplanemodul, auch Rückwandmodul genannt, mit einer aktiven Komponente auszustatten, über welches Steckplätze, je nach Bedarf, flexible und dynamisch veränderbar miteinander verbunden werden können. Die aktive Komponente ist ein Netzwerk-Kopplungselement, welches auch als Netzwerkweiche bezeichnet werden kann

Das oben genannte technische Problem wird zum einen durch die Merkmale des Anspruchs 1 sowie durch die Merkmale des Anspruchs 7, welcher ein modular aufgebautes Kommunikationssystem insbesondere zur industriellen Prozesssteuerung betrifft, gelöst.

Vorteilhafte Weiterbildungen und Ausgestaltungen sind Gegenstand der Unteransprüche.

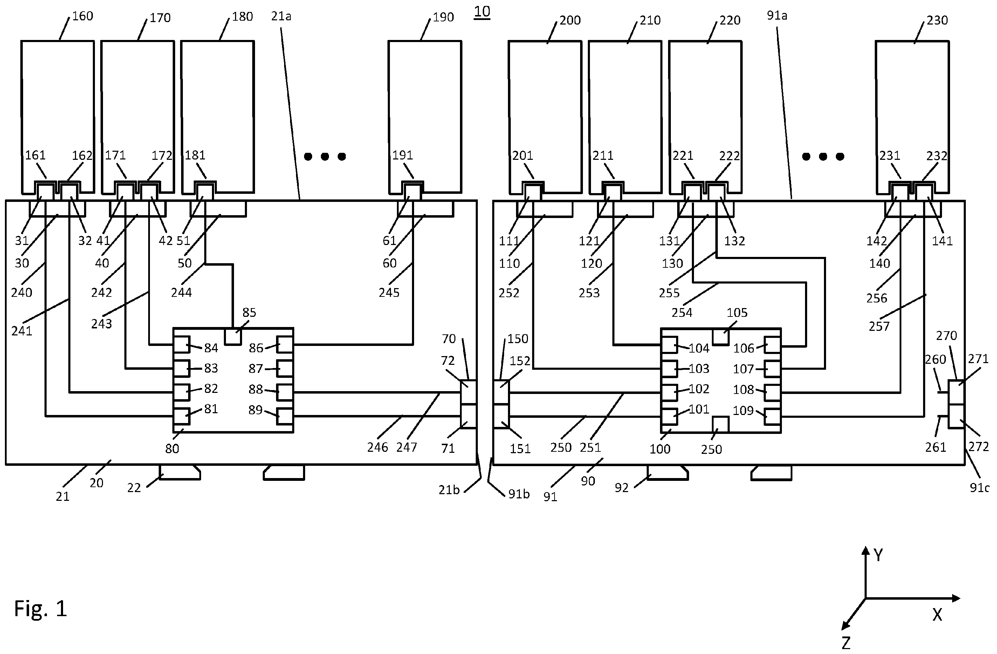

Die Erfindung wird nachfolgend anhand eines Ausführungsbeispiels in Verbindung mit einer beigefügten Figur 1 näher erläutert.

Figur 1 zeigt ein beispielhaftes modular aufgebautes Kommunikationssystem 10, welches insbesondere in einer Automatisierungsanlage zur industriellen Prozesssteuerung eingesetzt werden kann. Das beispielhaft dargestellte modular aufgebaute Kommunikationssystem 10 weist wenigstens ein Backplanemodul 20 zum elektrischen, optischen, kapazitiven oder induktiven Koppeln und vorzugsweise auch zum mechanischen Koppeln mehrerer Funktionsmodule 160-190 auf. Bei den Funktionsmodulen 160-190 handelt es sich vorzugsweise um Module, in denen jeweils zumindest eine elektronische Schaltung implementiert ist. Ein Funktionsmodul kann beispielsweise als Eingabe/Ausgabemodul, auch als I/O-Modul bekannt, als Steuerung, beispielsweise als eine speicherprogrammierbare Steuerung (SPS), realisiert sein, mit denen beispielsweise ein industrieller Prozess gesteuert werden kann. Eingabe/Ausgabemodule können Sensoren und Aktoren sein. Das beispielhafte, modular aufgebaute Kommunikationssystem 10 dient in diesem Fall insbesondere dazu, Prozessdaten über das Backplanemodul 20 und sofern vorhanden, über wenigstens ein weiteres Backplanemodul 90 zwischen den Funktionsmodulen zu übertragen.

Das Backplanemodul 20 weist einen Grundkörper 21 auf, der beispielsweise als Gehäuse ausgebildet sein kann. Innerhalb des Grundkörpers 21 ist ein Netzwerk-Kopplungselement 80 angeordnet, welches mehrere Ports 81-89 aufweist. Das Netzwerk-Kopplungselement 80 kann zum Beispiel ein Ethernet-Switch sein, der Datenpakete gemäß einem Ethernet-Protokoll gezielt zwischen seinen Ports 81-89 vermitteln kann. Am Grundkörper 21 ist wenigstens eine Anschlusseinrichtung 50 angeordnet, die zum elektrischen und vorzugsweise auch mechanischen Koppeln eines Funktionsmoduls, beispielsweise des Funktionsmoduls 180 ausgebildet ist. Die Anschlusseinrichtung 50 kann als Ethernet-Steckverbinder ausgebildet sein. Die Anschlusseinrichtung 50 weist wenigstens eine Kommunikationsschnittstelle 51 auf, die mit einem Port, beispielsweise dem Port 85 des Netzwerkelementes 80 über eine Signalleitung 244 verbunden ist. Das Funktionsmodul 180 weist zum Beispiel eine Anschlusseinrichtung mit einer Kommunikationsschnittstelle 181 auf, um mit der Anschlusseinrichtung 50 gekoppelt werden zu können. Am Grundkörper 21 ist vorzugsweise eine zweite Anschlusseinrichtung 30 angeordnet, die zum elektrischen und vorzugsweise auch mechanischen Koppeln eines Funktionsmoduls, beispielsweise des Funktionsmoduls 160, ausgebildet ist. Die zweite Anschlusseinrichtung 30 weist wenigstens zwei Kommunikationsschnittstellen 31 und 32 auf, die jeweils mit einem Port des Netzwerkkopplungselements 80 über separate Signalleitungen, die einen logischen Übertragungskanal bilden können, verbunden sind. Wie dargestellt, ist die Kommunikationsschnittstelle 31 über eine Signalleitung 240 mit dem Port 81 verbunden, während die Kommunikationsschnittstelle 32 über eine Signalleitung 241 mit dem Port 82 des Netzwerks-Kopplungselements 80 verbunden ist. Bereits an dieser Stelle sei erwähnt, dass unter Mitwirkung des Netzwerk-Kopplungselements 80 eine sogenannte Link-Aggregation-Funktion bezüglich der Anschlusseinrichtung 30 ausgeführt wird, bei der mehrere physische Schnittstellen, beispielsweise die Kommunikationsschnittstellen 31 und 32 logisch zu einem Kanal gebündelt werden, um beispielsweise den Datendurchsatz und die Ausfallsicherheit gegenüber einer einzigen Kommunikationsschnittstelle zu erhöhen. Hierfür wird beispielsweise das Link-Aggregation-Kontrollprotokoll (LACP) eingesetzt. Mit anderen Worten: das Netzwerk-Kopplungselement 80 ist dazu ausgebildet, dass LACP Protokoll auszuführen, um zum Beispiel Daten von und zu dem Funktionsmodul 160 über einen logischen Übertragungskanal, der die beiden Signalleitungen 240 und 241 bündelt, zu empfangen bzw. zu übertragen.

Um an die Anschlusseinrichtung 30 beispielsweise elektrisch angeschlossen werden zu können, weist das Funktionsmodul 160 eine Anschlusseinrichtung auf, die zwei Kommunikationsschnittstellen 161 und 162 enthält. Alternativ kann die Anschlusseinrichtung 30 optisch, kapazitiv oder induktiv mit den Kommunikationsschnittstellen 161 und 162 gekoppelt werden. Das Funktionsmodul 160 ist dazu ausgebildet, über einen, die beiden separaten Signalleitungen 240 und 241 umfassenden logischen Übertragungskanal Daten zum Netzwerk-Kopplungselement 80 zusenden und Daten vom Netzwerk-Kopplungselement 80 zu empfangen.

Am Grundkörper 21 kann eine weitere Anschlusseinrichtung 40 angeordnet sein, die mindestens zwei Kommunikationsschnittstellen 41 und 42 aufweisen kann, die jeweils mit einem Port des Netzwerk-Kopplungselementes 80 über separate Signalleitungen verbunden sind. Wie gezeigt, ist die Kommunikationsschnittstelle 41 über eine Signalleitung 242 mit dem Port 83 verbunden, während die Kommunikationsschnittstelle 42 über eine Signalleitung 243 mit dem Port 84 des Netzwerk-Kopplungselementes 80 verbunden ist. Die beiden Signalleitungen 242 und 243 können je nach Konfiguration wiederum einen logischen Übertragungskanal bilden. Um an die Anschlusseinrichtung 40 angeschlossen werden zu können, weist das Funktionsmodul 170 eine Anschlusseinrichtung auf, die zwei Kommunikationsschnittstellen 171 und 172 enthält. Die Anschlusseinrichtung 4 kann hierzu optisch, induktiv, kapazitiv oder elektrisch mit den Kommunikationsschnittstellen 171 und 172 gekoppelt werden. Das Funktionsmodul 170 ist dazu ausgebildet, über einen, die beiden separaten Signalleitungen 242 und 243 umfassenden logischen Übertragungskanal Daten zum Netzwerk-Kopplungselement 80 zusenden und Daten vom Netzwerk-Kopplungselement 80 zu empfangen.

Figur 1 zeigt eine vierte, am Grundkörper 21 angeordnete Anschlusseinrichtung 60, die wenigstens eine Kommunikationsschnittstelle 61 aufweisen kann, die mit dem Port 86 über eine Signalleitung 245 elektrisch verbunden ist. Das Funktionsmodul 190 weist eine Anschlusseinrichtung mit einer Kommunikationsschnittstelle 191 auf, die elektrisch, optisch, induktiv oder kapazitiv und vorzugsweise auch mechanisch mit der Anschlusseinrichtung 60 des Backplanemoduls 20 koppelbar ist. Angemerkt sei, dass, wie in Fig. 1 angedeutet, das Backplanemodul 20 auch mehr als die vier Anschlusseinrichtungen 30 bis 60 aufweisen kann.

Um das modular aufgebaute Kommunikationssystem 10 flexibel erweitern zu können, kann am Grundkörper 21 eine weitere Anschlusseinrichtung 70 vorgesehen sein, die wenigstens eine Kommunikationsschnittstelle aufweist. Im dargestellten Beispiel weist die Anschlusseinrichtung 70 zwei Kommunikationsschnittstellen 71 und 72 auf. Die Anschlusseinrichtung 70 ist zum elektrischen Verbinden und insbesondere auch zum mechanischen Koppeln des Backplanemoduls 20 mit einem weiteren Backplanemodul 90 ausgebildet.

Wie in Figur 1 dargestellt, sind die Anschlusseinrichtungen 30, 40, 50 und 60 bezüglich einer gedachten Linie, die parallel zur x-Achse des in Figur 1 gezeigten Koordinatensystems verläuft nebeneinander und im Abstand zueinander an einer Grundfläche 21a, welche in der xz-Ebene liegt, angeordnet. Die Anschlusseinrichtung 70 ist an einer senkrecht zur Grundfläche 21a verlaufenden Stirnfläche 21b des Grundkörpers 21 angeordnet, wobei die Stirnfläche 21b in der yz-Ebene des in Figur 1 gezeigten Koordinatensystems liegt. Angemerkt sei an dieser Stelle, dass die Grundfläche 21a eine Tiefe in -z-Richtung aufweisen kann, die beispielsweise der Tiefe bzw. Länge der Funktionsmodule 160-190 entspricht. Das Backplanemodul 20 kann ferner Rastelemente 22 aufweisen, um auf eine Tragschiene aufgerastet werden zu können.

Um mit dem Backplanemodul 20 elektrische und mechanisch gekoppelt werden zu können, weist das Backplanemodul 90 eine an einem Grundkörper 91 angeordnete Anschlusseinrichtung 150 auf, die vorzugsweise zwei Kommunikationsschnittstellen 151 und 152 aufweist, wobei die Anschlusseinrichtung 150 komplementär zur Anschlusseinrichtung 70 des Backplanemoduls 20 ausgebildet ist. Die Anschlusseinrichtung 150 ist an einer in der yz-Ebene liegende Stirnfläche 91b des Grundkörpers 91 angeordnet. Wie in der Figur 1 zu sehen, fluchten die Anschlusseinrichtungen 70 und 150 im aufgebauten Zustand. An den Stirnflächen 21b und 91b können komplementär ausgebildete Rastelemente zur mechanischen Kopplung der Backplanemodule 20 und 90 vorgesehen sein.

Ähnlich dem Backplanemodul 20 ist im Grundkörper 91 des Backplanemoduls 90 ein Netzwerk-Kopplungselement 100 mit mehreren Ports 101 bis 109 angeordnet, welches wiederum vorzugsweise als Ethernet-Switch ausgebildet sein kann. Ferner weist das Backplanemodul 90 zum Beispiel eine Anschlusseinrichtung 110 mit einer Kommunikationsschnittstelle 111, eine weitere Anschlusseinrichtung 120 mit einer Kommunikationsschnittstelle 121, eine weitere Anschlusseinrichtung 130 mit zwei Kommunikationsschnittstellen 131 und 132 und eine weitere Anschlusseinrichtung 140 mit zwei Kommunikationsschnittstellen 141 und 142 auf. Ähnlich dem Backplanemodul 20 sind die Anschlusseinrichtungen 110 bis 140 auf einer in der xz-Ebene liegenden Grundfläche 91a des Grundkörpers 91 angeordnet. An die Anschlusseinrichtungen 110 bis 140 kann jeweils ein Funktionsmodul angeschlossen werden. Allerdings kann das Backplanemodul 90 auch mehr als die vier Anschlusseinrichtungen 110 bis 140 aufweisen. Wie in der Figur 1 dargestellt, kann ein Funktionsmodul 200, welches eine Kommunikationsschnittstelle 201 aufweist, elektrisch, optisch, kapazitiv oder induktiv und vorzugsweise auch mechanisch mit der Anschlusseinrichtung 110 gekoppelt werden. Ein Funktionsmodul 210, welches eine Kommunikationsschnittstelle 211 aufweist, kann mit der Anschlusseinrichtung 120 des Backplanemoduls 90 elektrisch, optisch, kapazitiv oder induktiv und vorzugsweise auch mechanisch gekoppelt werden. Ein weiteres Funktionsmodul 220, welches zwei Kommunikationsschnittstellen 221 und 222 aufweist, kann elektrisch, optisch, kapazitiv oder induktiv und und vorzugsweise auch mechanisch mit der Anschlusseinrichtung 130, welche ebenfalls zwei Kommunikationsschnittstellen 131 und 132 aufweist elektrisch und mechanisch gekoppelt werden. Ein weiteres Kommunikationsmodul 230 mit zwei Kommunikationsschnittstellen 231 und 232 kann mit der Anschlusseinrichtung 140 elektrisch, optisch, kapazitiv oder induktiv und vorzugsweise auch mechanisch gekoppelt werden. Wie in der Figur 1 zu sehen, ist die Kommunikationsschnittstelle 111 über eine Signalleitung 252 mit einem Port 103 des Netzwerk-Kopplungselementes 100 verbunden. Die Kommunikationsschnittstelle 151 ist über eine Signalleitung 250 mit dem Port 101 verbunden, die Kommunikationsschnittstelle 152 ist über eine Signalleitung 251 mit dem Port 102 verbunden, die Kommunikationsschnittstelle 121 ist mit dem Port 104 verbunden, die beiden Kommunikationsschnittstellen 131 und 132 der Anschlusseinrichtung 130 sind über eine Signalleitung 254 mit dem Port 106 bzw. über eine Signalleitung 255 mit dem Port 107 verbunden, während die beiden Kommunikationsschnittstellen 141 und 142 der Anschlusseinrichtung 140 über eine Signalleitung 257 mit dem Port 109 und über eine Signalleitung 256 mit dem Port 108 des Netzwerk-Kommunikationselements 100 verbunden sind.

Angemerkt sei, dass die beiden Netzwerk-Kopplungselemente 80 und 100 gemäß dem aus der Netzwerktechnik bekannten Stacking-Verfahren derart miteinander verbunden werden können, dass sie und somit die beiden Backplanemodule 20 und 90 nach außen hin als eine Systemeinheit mit nur einer IP-Adresse auftreten. Hierzu kann zum Beispiel eine Verbindung, welche die Signalleitungen 247 und 251 oder die Signalleitungen 246 und 250 umfasst oder eine separate Verbindung (nicht dargestellt) benutzt werden.

An einer der Stirnfläche 91b gegenüberliegenden Stirnfläche 91c kann eine weitere Anschlusseinrichtung 270 am Grundkörper 91 des Backplanemoduls 90 vorgesehen sein, die beispielsweise zwei Kommunikationsschnittstellen 271 und 272 aufweist, die über eine Signalleitung 261 beispielsweise mit dem Port 250 und über eine Signalleitung 260 mit dem Port 105 des Netzwerk-Kopplungselements 100 verbunden sind. An die Anschlusseinrichtung 270 kann die Anschlusseinrichtung eines weiteren Backplanemoduls (nicht dargestellt) angeschlossen werden. Auch der Grundkörper 91 des Backplanemoduls 90 kann Rastelemente 92 zum Aufrasten auf eine Tragschiene aufweisen, die im dargestellten Ausführungsbeispiel parallel zur x-Achse verlaufen würde.

Die beiden Netzwerk-Kopplungselemente 80 und 100 können jeweils als VLAN-fähiges Netzwerk-Kopplungselement ausgebildet sein. Auf diese Weise ist es möglich innerhalb des Netzwerk-Kopplungselement 80 oder des NetzwerkKopplungselements 100 oder sogar über die beide Netzwerk-Kopplungselemente 80 und 100 eine virtuelle Verbindung oder ein logisches Teilnetz zwischen einzelnen Anschlusseinrichtungen und somit zwischen einigen der Funktionsmodule 160 bis 230, beispielsweise zwischen den Funktionsmodulen 160 und 230 aufzubauen. Beispielsweise kann auf diese Weise zwischen der Anschlusseinrichtung 30 und der Anschlusseinrichtung 140 über die Signalleitungen 240, 246, 250 und 257 eine virtuelle Verbindung aufgebaut werden. Auf diese Weise lassen sich Funktionen, wie zum Beispiel die Synchronisation redundanter Funktionsmodule, beispielsweise der Funktionsmodule 160 und 230 realisieren, ohne dass hierfür separate, ausschließlich für diese Funktion vorgesehene Kommunikationstechnologien implementiert werden müssen.

Dank des Einsatzes von Backplanemodulen, die jeweils aktive Netzwerk-Kopplungselemente aufweisen, kann in einfacher und flexibler Art und Weise ein komplexes, modular aufgebautes Kommunikationssystem 10 implementiert werden, welches insbesondere zur industriellen Prozesssteuerung ausgebildet sein kann.

Zumindest einige der obigen beispielhaft erläuterten Aspekte werden nachfolgend noch einmal zusammengefasst.

Es wird ein Backplanemodul zum Koppeln mehrerer Funktionsmodule bereitgestellt, wobei beispielhaft das in Figur 1 gezeigte Backplanemodul 20 bzw. das Backplanemodul 90 zugrunde gelegt wird. An das Backplanemodul 20 können beispielsweise Funktionsmodule 160 bis 190 und an das Backplanemodule 90 beispielsweise Funktionsmodule 200 bis 230 angeschlossen werden. Das Backplanemodul 20 bzw. 90 kann folgende Merkmale aufweisen:
einen Grundkörper 21; 91,
ein innerhalb des Grundkörper 21; 91 angeordnetes Netzwerk-Kopplungselement 80; 100 mit mehreren Ports 81-89; 101-109, wenigstens eine am Grundkörper 21; 91 angeordnete erste Anschlusseinrichtung 50; 110, die zum Koppeln eines Funktionsmoduls 180; 200 ausgebildet ist, wobei die wenigstens eine erste Anschlusseinrichtung 50; 110 wenigstens eine Kommunikationsschnittstelle 51; 111 aufweist, die mit einem Port 85; 103 des NetzwerkKopplungselements 80; 100 über eine Signalleitung 244; 252 verbunden ist,

wenigstens eine am Grundkörper 21; 91 angeordnete zweite Anschlusseinrichtung 30; 130, die zum Koppeln eines Funktionsmoduls 160; 220 ausgebildet ist, wobei die wenigstens eine zweite Anschlusseinrichtung 30; 130 wenigstens zwei Kommunikationsschnittstellen 31, 32; 131, 132 aufweist, die jeweils mit einem der Ports 81, 82; 106, 107 des Netzwerk-Kopplungselements 80; 100 über jeweils eine separate Signalleitung 240, 241; 254, 255 verbunden sind, wobei das Netzwerk-Kopplungselement 80; 100 zum Empfangen und Senden von Datenpaketen von und zu der wenigstens einen ersten Anschlusseinrichtung 50; 110 und der wenigstens einen zweiten Anschlusseinrichtung 30; 130 ausgebildet ist. Die separaten Signalleitungen 240, 241; 254, 255, über welche die wenigstens zwei Kommunikationsschnittstellen 31, 32; 131, 132 jeweils mit einem der Ports 81, 82; 106, 107 das NetzwerkKopplungselements 80; 100 verbunden sind, bilden zusammen einen logischen Übertragungskanal, und das Netzwerk-Kopplungselement 80; 100 ist zum Ausführen eines Link-Aggregation-Kontrollprogramms zum Empfangen und Senden von Datenpaketen über den logischen Übertragungskanal ausgebildet.

Vorzugsweise ist am Grundkörper 21; 91 wenigstens eine dritte Anschlusseinrichtung 70; 270 mit wenigstens einer Kommunikationsschnittstelle 71, 72; 271, 272 angeordnet ist, die zum Koppeln des Backplanemoduls 20; 90 mit einem weiteren Backplanemodul ausgebildet ist.

Eine kompakte und platzsparende Anordnung ergibt sich beispielsweise dadurch, dass die wenigstens eine erste Anschlusseinrichtung 50; 110 und die wenigstens eine zweite Anschlusseinrichtung 30; 130 bezüglich einer gedachten Linie nebeneinander und in Abstand zueinander an einer Grundfläche 21a; 91a des Grundkörpers 21; 91 angeordnet sind, und dass
die wenigstens eine dritte Anschlusseinrichtung 70; 150 an einer senkrecht zur Grundfläche 21a; 91a verlaufenden Fläche 21b; 91b des Grundkörpers 21; 91 angeordnet ist.

Zweckmäßigerweise kann das Netzwerk-Kopplungselement 80; 100 als Ethernet-Switch ausgebildet sein.

Die Leistungsfähigkeit des Backplanemoduls 20; 90 kann dadurch erhöht werden, dass das Netzwerk-Kopplungselement 80; 100 optional oder zusätzlich als VLAN-fähiges Netzwerk-Kopplungselement ausgebildet sein kann.

Um das Backplanemodul 20; 90 zum Beispiel in einen Schaltschrank einbauen zu können, können am Grundkörper 21; 91 Montageelemente 22; 92 zum Montieren des Backplanemoduls 20; 90 an einer Tragschiene ausgebildet sein.

Gemäß einem weiteren Aspekt wird ein modular aufgebautes Kommunikationssystem 10, welches insbesondere zur industriellen Prozesssteuerung ausgebildet sein kann, vorgesehen, welches folgende Merkmale aufweisen kann: ein erstes Backplanemodul 20, wie zuvor erläutert,
wenigstens ein erstes Funktionsmodul 180, das eine Anschlusseinrichtung mit wenigstens einer Kommunikationsschnittstelle 181 aufweist, wobei das wenigstens eine erste Funktionsmodul 180 über die wenigstens eine erste Anschlusseinrichtung 50 mit dem ersten Backplanemodul 20 optisch, kapazitiv, elektrisch oder induktiv und vorzugsweise auch mechanisch gekoppelt ist,
wenigstens ein zweites Funktionsmodul 160, welches eine Anschlusseinrichtung mit wenigstens zwei Kommunikationsschnittstellen 161, 162 aufweist und welches über die zweite Anschlusseinrichtung 30 mit dem ersten Backplanemodul 20 optisch, kapazitiv, elektrisch oder induktiv und vorzugsweise auch mechanisch gekoppelt ist.

Eine vorteilhafte Weiterbildung sieht ein zweites, mit dem ersten Backplanemodul 20 gekoppeltes Backplanemodul 90, welches zuvor beschrieben worden ist, vor, wobei das Netzwerk-Kopplungselement 80 des ersten Backplanemoduls 20 und das Netzwerk-Kopplungselement 100 des zweiten Backplanemoduls 90 über wenigstens eine elektrische Verbindung (246, 250; 247, 251) miteinander verbunden sind. Eine elektrische Verbindung kann Signalleitungen 246 und 250 aufweisen. Eine alternative oder zusätzliche Verbindung kann Signalleitungen 247 und 251 aufweisen. Es ist wenigstens ein drittes Funktionsmodul 200 vorgesehen, das eine Anschlusseinrichtung mit wenigstens einer Kommunikationsschnittstelle 201 aufweist, wobei das wenigstens eine dritte Funktionsmodul 200 über die wenigstens eine erste Anschlusseinrichtung 110 mit dem zweiten Backplanemodul 90 optisch, kapazitiv, elektrisch oder induktiv und vorzugsweise auch mechanisch gekoppelt ist. Weiterhin ist wenigstens ein viertes Funktionsmodul 220 vorgesehen, welches eine Anschlusseinrichtung mit wenigstens zwei Kommunikationsschnittstellen 221, 222 aufweist und welches über die wenigstens eine zweite Anschlusseinrichtung 130 mit dem zweiten Backplanemodul 90 optisch, kapazitiv, elektrisch oder induktiv und vorzugsweise auch mechanisch gekoppelt ist.

Um zum Beispiel den Datendurchsatz zwischen wenigstens zwei Funktionsmodulen erhöhen zu können, werden die Funktionsmodule, zum Beispiel die Funktionsmodule 160 und 170 mittels des Netzwerk-Kopplungselements 80 über wenigstens zwei separate elektrische Verbindungen, die einen logischen Übertragungskanal bilden, miteinander verbunden. In dem beispielhaften Fall weist die eine elektrische Verbindung zum Beispiel die Signalleitungen 240 und 242 auf, während die andere Verbindung die Signalleitungen 241 und 243 umfassen kann.

Vorzugsweise können wenigstens zwei der Funktionsmodule, zum Beispiel die Funktionsmodule 160 und 230 über eine virtuelle Verbindung kommunizieren. In diesem Fall kann eine virtuelle Verbindung über die Kommunikationsschnittstelle 31, die Signalleitung 240, die Ports 81 und 89 des Netzwerk-Kopplungselements 80, die Signalleitungen 246 und 250, die Ports 101 und 109 des Netzwerk-Kopplungselements 100, die Signalleitung 257 und die Kommunikationsschnittstelle 232 aufgebaut werden.

Vorzugsweise kann jedes der Funktionsmoduls 160-230 als I/O-Modul, Kommunikationsmodul oder als Steuerung ausgebildet sein.

Angemerkt sei noch, dass es sich bei den Kommunikationsschnittstellen im einfachsten Fall um elektrische Anschlüsse handeln kann. Sie können aber auch als induktive, optische oder kapazitive Kopplungselemente ausgebildet sein.

## Patentansprüche

1. Backplanemodul (20; 90) zum Koppeln mehrerer Funktionsmodule (160-190; 200-230), aufweisend:
einen Grundkörper (21; 91),
ein innerhalb des Grundkörper (21; 91) angeordnetes Netzwerk-Kopplungselement (80; 100) mit mehreren Ports (81-89; 101-109),
wenigstens eine am Grundkörper (21; 91) angeordnete erste Anschlusseinrichtung (50; 110), die zum Koppeln eines Funktionsmoduls (180; 200) ausgebildet ist,
wobei die wenigstens eine erste Anschlusseinrichtung (50; 110) wenigstens eine Kommunikationsschnittstelle (51; 111) aufweist, die mit einem Port (85; 103) des Netzwerk-Kopplungselements (80; 100) über eine Signalleitung (244; 252) verbunden ist,
wenigstens eine am Grundkörper (21; 91) angeordnete zweite Anschlusseinrichtung (30; 130), die zum Koppeln eines Funktionsmoduls (160; 220) ausgebildet ist, wobei die wenigstens eine zweite Anschlusseinrichtung (30; 130) wenigstens zwei Kommunikationsschnittstellen (31, 32; 131, 132) aufweist, die jeweils mit einem der Ports (81, 82; 106, 107) des Netzwerk-Kopplungselements (80; 100) über jeweils eine separate Signalleitung (240, 241; 254, 255) verbunden sind, wobei das Netzwerk-Kopplungselement (80; 100) zum Empfangen und Senden von Datenpaketen von und zu der wenigstens einen ersten Anschlusseinrichtung (50; 110) und der wenigstens einen zweiten Anschlusseinrichtung (30; 130) ausgebildet ist,
**dadurch gekennzeichnet, dass**
die separaten Signalleitungen (240, 241; 254, 255), über welche die wenigstens zwei Kommunikationsschnittstellen (31, 32; 131, 132) jeweils mit einem der Ports (81, 82; 106, 107) des Netzwerk-Kopplungselements (80; 100) verbunden sind, zusammen einen logischen Übertragungskanal bilden, und das Netzwerk-Kopplungselement (80; 100) zum Ausführen eines Link-Aggregation-Kontrollprogramms zum Empfangen und Senden von Datenpaketen über den logischen Übertragungskanal ausgebildet ist.

2. Backplanemodul nach Anspruch 1,
**dadurch gekennzeichnet, dass**
am Grundkörper (21; 91) wenigstens eine dritte Anschlusseinrichtung (70; 270) mit wenigstens einer Kommunikationsschnittstelle (71, 72; 271, 272) angeordnet ist, die zum Koppeln des Backplanemoduls (20; 90) mit einem weiteren Backplanemodul ausgebildet ist, wobei das weitere Backplanemodul (20; 90) eine komplementäre Anschlusseinrichtung (150) umfasst.

3. Backplanemodul nach Anspruch 2,
**dadurch gekennzeichnet, dass**
die wenigstens eine erste Anschlusseinrichtung (50; 110) und die wenigstens eine zweite Anschlusseinrichtung (30; 130) bezüglich einer gedachten Linie nebeneinander und in Abstand zueinander an einer Grundfläche (21a; 91a) des Grundkörpers (21; 91) angeordnet sind, und dass die wenigstens eine dritte Anschlusseinrichtung (70; 150) und/oder die komplementäre Anschlusseinrichtung (150) an einer senkrecht zur Grundfläche (21a; 91a) verlaufenden Fläche (21b; 91b) des Grundkörpers (21; 91) angeordnet ist.

4. Backplanemodul nach einem der vorstehenden Ansprüche **dadurch gekennzeichnet, dass**
das Netzwerk-Kopplungselement (80; 100) ein Ethernet-Switch ist.

5. Backplanemodul nach einem der vorstehenden Ansprüche, **dadurch gekennzeichnet, dass**
das Netzwerk-Kopplungselement (80; 100) ein VLAN-fähiges Netzwerk-Kopplungselement ist.

6. Backplanemodul nach einem der vorstehenden Ansprüche, **dadurch gekennzeichnet, dass**
am Grundkörper (21; 91) Montageelemente (22; 92) zum Montieren des Backplanemoduls (20; 90) an einer Tragschiene ausgebildet sind.

7. Modular aufgebautes Kommunikationssystem (10) insbesondere zur industriellen Prozesssteuerung, aufweisend:
ein erstes Backplanemodul (20) nach einem der vorstehenden Ansprüche,
wenigstens ein erstes Funktionsmodul (180), das eine Anschlusseinrichtung mit wenigstens einer Kommunikationsschnittstelle (181) aufweist, wobei das wenigstens eine erste Funktionsmodul (180) über die wenigstens eine erste Anschlusseinrichtung (50) mit dem ersten Backplanemodul (20) gekoppelt ist,
wenigstens ein zweites Funktionsmodul (160), welches eine Anschlusseinrichtung mit wenigstens zwei Kommunikationsschnittstellen (161, 162) aufweist und welches über die zweite Anschlusseinrichtung (30) mit dem ersten Backplanemodul (20) gekoppelt ist.

8. Modular aufgebautes Kommunikationssystem nach Anspruch 7,
**gekennzeichnet durch**
ein zweites, mit dem ersten Backplanemodul (20) gekoppeltes Backplanemodul (90) nach einem Ansprüche 1 bis 6, wobei
das Netzwerk-Kopplungselement (80) des ersten Backplanemoduls (20) und das Netzwerk-Kopplungselement (100) des zweiten Backplanemoduls (90) über wenigstens eine elektrische Verbindung (246, 250; 247, 251) miteinander verbunden sind, wenigstens ein drittes Funktionsmodul (200), das eine Anschlusseinrichtung mit wenigstens einer Kommunikationsschnittstelle (201) aufweist, wobei das wenigstens eine dritte Funktionsmodul (200) über die wenigstens eine erste Anschlusseinrichtung (110) mit dem zweiten Backplanemodul (90) gekoppelt ist, wenigstens ein viertes Funktionsmodul (220), welches eine Anschlusseinrichtung mit wenigstens zwei Kommunikationsschnittstellen (221, 222) aufweist und welches über die wenigstens eine zweite Anschlusseinrichtung (130) mit dem zweiten Backplanemodul (90) gekoppelt ist.

9. Modular aufgebautes Kommunikationssystem nach Anspruch 8,
**dadurch gekennzeichnet, dass**
wenigstens zwei der Funktionsmodule (160-230) über wenigstens zwei Verbindungen, die einen logischen Übertragungskanal bilden, miteinander verbunden sind.

10. Modular aufgebautes Kommunikationssystem nach Anspruch 8 oder 9,
**dadurch gekennzeichnet, dass**
wenigstens zwei der Funktionsmodule (160-230) über eine virtuelle Verbindung kommunizieren.

11. Modular aufgebautes Kommunikationssystem nach einem der Ansprüche 7 bis 10,
**dadurch gekennzeichnet, dass**
jedes der Funktionsmodule (160-230) als I/O-Modul, Kommunikationsmodul oder als Steuerung ausgebildet ist.

## Claims

1. Backplane module (20; 90) for coupling a plurality of functional modules (160-190; 200-230), comprising:
a base body (21; 91),
a network coupling element (80; 100) arranged within the base body (21; 91) and having a plurality of ports (81-89; 101-109),
at least one first terminal device (50; 110) arranged on the base body (21; 91), wherein the at least one first terminal device (50; 110) is configured to be connected to a functional module (180; 200), wherein the at least one first terminal device (50; 110) comprises at least one communication interface (51; 111) which is connected to a port (85; 103) of the network coupling element (80; 100) via a signal line (244; 252),
at least one second terminal device (30; 130) arranged on the base body (21; 91), wherein at least one second terminal device (30; 130) is configured to be connected to a functional module (160; 220), wherein the at least one second connection device (30; 130) comprises at least two communication interfaces (31, 32; 131, 132), each of which is connected to one of the ports (81, 82; 106, 107) of the network coupling element (80; 100) via a respective separate signal line (240, 241; 254, 255), wherein the network coupling element (80; 100) is configured to receive and transmit data packets from and to the at least one first terminal device (50; 110) and the at least one second terminal device (30; 130),
**characterized in that**
the separate signal lines (240, 241; 254, 255), via which the at least two communication interfaces (31, 32; 131, 132) are each connected to one of the ports (81, 82; 106, 107) of the network coupling element (80; 100), together form a logical transmission channel, and that
the network coupling element (80; 100) is configured to execute a link aggregation control program for receiving and transmitting data packets via the logical transmission channel.

2. Backplane module according to claim 1,
**characterized in that**
at least one third terminal device (70; 270) having at least one communication interface (71, 72; 271, 272) is arranged on the base body (21; 91), wherein the at least one third terminal device (70; 270) is configured to couple the backplane module (20; 90) to a further backplane module, wherein the further backplane module (20; 90) comprises a complementary terminal device (150).

3. Backplane module according to claim 2,
**characterized in that**
the at least one first terminal device (50; 110) and the at least one second terminal device (30; 130) are arranged side by side and spaced apart from one another relative to an imaginary line on a base surface (21a; 91a) of the base body (21; 91), and that
the at least one third terminal device (70; 150) and/or the complementary terminal device (150) is arranged on a surface (21b; 91b) of the base body (21; 91) running perpendicular to the base surface (21a; 91a).

4. Backplane module according to any one of the preceding claims, **characterized in that**
the network coupling element (80; 100) is an Ethernet switch.

5. A backplane module according to any one of the preceding claims,
**characterized in that**
the network coupling element (80; 100) is a VLAN-capable network coupling element.

6. A backplane module according to any one of the preceding claims,
**characterized in that**
mounting elements (22; 92) are formed on the base body (21; 91) for mounting the backplane module (20; 90) on a mounting rail.

7. A modularly constructed communication system (10), in particular for industrial process control, comprising:
a first backplane module (20) according to any one of the preceding claims,
at least one first functional module (180) comprising a terminal device with at least one communication interface (181), wherein the at least one first functional module (180) is coupled to the first backplane module (20) via the at least one first terminal device (50),
at least one second functional module (160), which comprises a terminal device with at least two communication interfaces (161, 162) and which is coupled to the first backplane module (20) via the second terminal device (30).

8. A modular communication system according to claim 7, **characterized by**
a second backplane module (90) coupled to the first backplane module (20) according to any one of the claims 1 to 6, wherein
the network coupling element (80) of the first backplane module (20) and the network coupling element (100) of the second backplane module (90) are interconnected via at least one electrical connection (246, 250; 247, 251);
at least one third functional module (200) comprising a terminal device with at least one communication interface (201), wherein the at least one third functional module (200) is coupled to the second backplane module (90) via the at least one first terminal device (110),
at least one fourth functional module (220), which comprises a terminal device with at least two communication interfaces (221, 222) and which is coupled to the second backplane module (90) via the at least one second terminal device (130).

9. A modular communication system according to claim 8, **characterized in that**
at least two of the functional modules (160-230) are interconnected via at least two connections which form a logical transmission channel.

10. A modular communication system according to claim 8 or 9,
**characterized in that**
at least two of the functional modules (160-230) communicate via a virtual connection.

11. A modular communication system according to any one of claims 7 to 10,
**characterized in that**
each of the functional modules (160-230) is configured as an I/O module, a communication module or a controller.

## Revendications

1. Module fond de panier (20 ; 90) pour le couplage de plusieurs modules fonctionnels (160-190 ; 200-230), présentant :
un corps de base (21 ; 91),
un élément de couplage réseau (80 ; 100) disposé à l'intérieur du corps de base (21 ; 91) avec plusieurs ports (81-89 ; 101-109),
au moins un premier dispositif de connexion (50 ; 110) disposé sur le corps de base (21 ; 91), configuré pour coupler un module fonctionnel (180 ; 200),
dans lequel l'au moins un premier dispositif de connexion (50 ; 110) présente au moins une interface de communication (51 ; 111) qui est connectée à un port (85 ; 103) de l'élément de couplage réseau (80 ; 100) par le biais d'une ligne de signal (244 ; 252),
au moins un deuxième dispositif de connexion (30 ; 130) disposé sur le corps de base (21 ; 91), configuré pour le couplage d'un module fonctionnel (160 ; 220), l'au moins un deuxième dispositif de connexion (30 ; 130) possédant au moins deux interfaces de communication (31, 32 ; 131, 132), chacune étant connectée à l'un des ports (81, 82 ; 106, 107) de l'élément de couplage réseau (80 ; 100) par le biais d'une ligne de signal distincte (240, 241 ; 254, 255), l'élément de couplage réseau (80 ; 100) étant configuré pour recevoir et envoyer des paquets de données en provenance et à destination du premier dispositif de connexion (50 ; 110) et de l'au moins un deuxième dispositif de connexion (30 ; 130),
**caractérisé en ce que**
les lignes de signal distinctes (240, 241 ; 254, 255), par le biais desquelles les au moins deux interfaces de communication (31, 32 ; 131, 132) sont chacune connectées à l'un des ports (81, 82 ; 106, 107) de l'élément de couplage réseau (80 ; 100), forment ensemble un canal de transmission logique, et l'élément de couplage réseau (80 ; 100) est configuré pour exécuter un programme de commande d'agrégation de liaisons pour recevoir et envoyer des paquets de données par le biais du canal de transmission logique.

2. Module fond de panier selon la revendication 1,
**caractérisé en ce que**
sur le corps de base (21 ; 91) est disposé au moins un troisième dispositif de connexion (70 ; 270) avec au moins une interface de communication (71, 72 ; 271, 272), configuré pour coupler le module fond de panier (20 ; 90) à un autre module fond de panier, l'autre module fond de panier (20 ; 90) comprenant un dispositif de connexion complémentaire (150).

3. Module fond de panier selon la revendication 2,
**caractérisé en ce que**
l'au moins un premier dispositif de connexion (50 ; 110) et l'au moins un deuxième dispositif de connexion (30 ; 130) sont disposés côte à côte et à distance l'un de l'autre par rapport à une ligne imaginaire sur une surface de base (21a ; 91a) du corps de base (21 ; 91), et **en ce que** l'au moins un troisième dispositif de connexion (70 ; 150) et/ou le dispositif de connexion complémentaire (150) sont disposés sur une surface (21b ; 91b) du corps de base (21 ; 91) s'étendant perpendiculairement à la surface de base (21a ; 91a).

4. Module fond de panier selon l'une quelconque des revendications précédentes,
**caractérisé en ce que**
l'élément de couplage réseau (80 ; 100) est un commutateur Ethernet.

5. Module fond de panier selon l'une quelconque des revendications précédentes,
**caractérisé en ce que**
l'élément de couplage réseau (80 ; 100) est un élément de couplage réseau compatible VLAN.

6. Module fond de panier selon l'une quelconque des revendications précédentes,
**caractérisé en ce que**
des éléments de montage (22 ; 92) servant à monter le module fond de panier (20 ; 90) sur un rail de support sont formés sur le corps de base (21 ; 91).

7. Système de communication de construction modulaire (10) spécialement conçu pour la commande des processus industriels, présentant :
un premier module fond de panier (20) selon l'une quelconque des revendications précédentes,
au moins un premier module fonctionnel (180) qui présente un dispositif de connexion comportant au moins une interface de communication (181), l'au moins un premier module fonctionnel (180) étant couplé au premier module fond de panier (20) par le biais de l'au moins un premier dispositif de connexion (50),
au moins un deuxième module fonctionnel (160) qui présente un dispositif de connexion comportant au moins deux interfaces de communication (161, 162) et qui est couplé au premier module fond de panier (20) par le biais du deuxième dispositif de connexion (30).

8. Système de communication de construction modulaire selon la revendication 7, **caractérisé par**
un deuxième module fond de panier (90) couplé au premier module fond de panier (20) selon l'une des revendications 1 à 6, dans lequel
l'élément de couplage réseau (80) du premier module fond de panier (20) et l'élément de couplage réseau (100) du deuxième module fond de panier (90) sont connectés entre eux par le biais d'au moins une connexion électrique (246, 250 ; 247, 251), au moins un troisième module fonctionnel (200) qui présente un dispositif de connexion comportant au moins une interface de communication (201), dans lequel l'au moins un troisième module fonctionnel (200) est couplé au deuxième module fond de panier (90) par le biais de l'au moins un premier dispositif de connexion (110),
au moins un quatrième module fonctionnel (220) qui présente un dispositif de connexion comportant au moins deux interfaces de communication (221, 222) et qui est couplé au deuxième module fond de panier (90) par le biais de l'au moins un deuxième dispositif de connexion (130).

9. Système de communication de construction modulaire selon la revendication 8,
**caractérisé en ce que**
au moins deux des modules fonctionnels (160-230) sont connectés entre eux par le biais d'au moins deux connexions qui forment un canal de transmission logique.

10. Système de communication de construction modulaire selon la revendication 8 ou 9, **caractérisé en ce que**
au moins deux des modules fonctionnels (160-230) communiquent par le biais d'une connexion virtuelle.

11. Système de communication de construction modulaire selon l'une des revendications 7 à 10,
**caractérisé en ce que**
chacun des modules fonctionnels (160-230) est conçu comme un module d'E/S, un module de communication ou un organe de commande.
